# EUROPEAN PATENT APPLICATION

(11) **EP 1 659 639 A1**
(43) Date of publication of application: **24.05.2006**
(21) Application number: 04771410.0
(22) Date of filing: 03.08.2004
(51) Int. Cl.: H01L 31/04, H01M 14/00

(54) **PHOTOELECTRIC CONVERSION ELEMENT**

(30) Priority: 26.08.2003 JP 2003301712
(71) Applicant: Nippon Oil Corporation, Tokyo 105-8412 (JP)
(72) Inventor: Nakayama, K., Nippon Oil Corp., Yokohama-shi, Kanagawa 2310815 (JP); Nishikitani, Y., Nippon Oil corp., Yokohama-shi, Kanagawa 2310815 (JP)
(74) Representative: Janson, Ronny
(86) International application number: PCT/JP2004/011423
(87) International publication number: WO 2005/020335

(57) **Abstract**

The present invention provide an all solid-state photoelectric conversion device which comprises a semiconductor, an electrically conductive substrate arranged on one surface of the semiconductor and forming an ohmic junction therewith, an electrically conductive film arranged on the other surrface and forming a Schottky junction with the semiconductor, and a sensitizing dye layer arranged on the electrically conductive film, the roughness factor of the surface of the semiconductor forming a Schottky junction being 5 or greater. The photoelectric conversion device has a large effective surface area and a high durability and can be manufactured at a low cost.

## Description

### [Field of the Invention]

This invention relates to novel photoelectric conversion device using a dye-sensitized semiconductor.

### [Background of the Invention]

The dye-sensitized solar cell exhibited by Gratzel et al. in 1991 is a wet solar cell with working electrodes formed of a porous titanium oxide film spectral-sensitized with a ruthenium complex and reported to have performances equivalent to those of a silicon solar cell (see Non-Patent Document 1 below). The method employed by Gratzel et al. has advantages that a photoelectric conversion device can be manufactured inexpensively because cheap metal oxide semiconductors such as titanium oxide can be used without refining it to a certain high purity, and the resulting device can convert light within substantially the whole visible ray wavelength region to electricity due to its broad dye absorption. However, on the other hand, the photoelectric conversion device of this type is a wet solar cell in which one electrode is electrically connected to the counter electrode through an electrolyte solution and thus would be extremely reduced in photoelectric conversion efficiency due to depletion of the electrolyte and would no longer work as the device after it is used for a prolonged period. In order to avoid the disadvantage caused by depletion of the electrolyte with time, an all solid state type photoelectric conversion device was proposed which is manufactured using a positive hole transport material such as CuI and CuSCN. However, this all solid state type photoelectric conversion device has a problem that it is significantly deteriorated in photoelectric conversion characteristics such as short-circuit current density in a short time.

Under these circumstances, Tang et al. exhibited a dye-sensitized photoelectric conversion device of a completely new type formed by sandwiching a titanium oxide layer 2 between a titanium electrode supporting substrate 1 and a gold electrode 3 and then coating thereon a dye molecular layer 4 as shown in Fig. 1 (see Non-Patent Document 2 below) . The titanium oxide layer 2 of this device forms on its one surface a Schottky junction with the gold electrode 2 and on the other surface an ohmic junction with the titanium electrode 1. The dye layer adsorbed on the gold electrode surface is oxidized by photoexcitation, and the photoexcited electrons flow from the dye layer to the titanium oxide layer across the Schottky barrier between the gold electrode and the titanium oxide layer. The oxidized dye is automatically reproduced by electron-donation from the gold electrode layer. Therefore, the device does not require any electrolyte. Furthermore, since this photoelectric conversion device comprises highly durable materials, it can be enhanced in practicability than the conventional dye-sensitized solar cells. However, on the other hand, at the present time, the photoelectric conversion device taught by Tang et al. has a problem that it is very small in short-circuit current density. The photoelectric conversion efficiency of this device can be increased by enlarging the unit surface area of the semiconductor film layer such that the absorbing amount of the sensitizing dye and the current value of the device are increased. Alternatively, a highly practicable dye sensitized photoelectric conversion device with high photoelectric conversion efficiency and excellent impact resistance can be manufactured if a thick porous oxide semiconductor film layer can be formed on the substrate.
1) Non-Patent Document 1
   "Nature" (Great Britain) p. 737-740, by Michael
   Gratzel et al., October 24, 1991
2) Non-Patent Document 2
   "Nature" (Great Britain) p. 616-618, by Jing
   Tang et al, February 6, 2003

### [Disclosure of the Invention]

The present invention was achieved in consideration of these situations and has an object to provide an all solid state type dye sensitized photoelectric conversion device which has a semiconductor film with a large roughness factor formed on a surface of a substrate at a low cost and is thus large in short circuit current density and excellent in durability.

That is, the present invention relates to a photoelectric conversion device which comprises a semiconductor, an electrically conductive substrate arranged on one surface of the semiconductor and forming an ohmic junction therewith, an electrically conductive film arranged on the other surface and forming a Schottky junction with the semiconductor, and a sensitizing dye layer arranged on the electrically conductive film, the roughness factor of the surface of the semiconductor forming a Schottky junction being 5 or greater.

The present invention also relates to the photoelectric conversion device wherein the Schottky barrier value between the semiconductor and the electrically conductive film forming a Schottky junction therewith is from 0.2 eV to 2.5 eV.

The present invention also relates to the photoelectric conversion device wherein the semiconductor is an oxide semiconductor.

The present invention also relates to the photoelectric conversion device wherein the oxide semiconductor is selected from the group consisting of titanium oxide, tantalum oxide, niobium oxide and zirconium oxide.

The present invention also relates to the photoelectric conversion device wherein the electrically conductive substrate forming an ohmic junction with the semiconductor is a transparent electrically conductive substrate formed of a metal selected from titanium, tantalum, niobium and zirconium, an alloy containing mainly any of these metals, or an oxide of any of these metals.

Furthermore, the present invention relates to a process of manufacturing a photoelectric conversion device which comprises steps of: forming on an electrically conductive substrate a semiconductor forming an ohmic junction with the substrate; increasing the roughness factor of the surface of the semiconductor forming a Schottky junction with an electrically conductive film to 5 or greater; forming an electrically conductive film by joining on the semiconductor surface whose roughness factor is increased to 5 or greater an electrically conductive material forming a Schottky junction with the semiconductor; and forming on the film a sensitizing dye layer.

The present invention also relates a process of manufacturing a photoelectric conversion device which comprises steps of: increasing the roughness factor of one surface of a semiconductor to 5 or greater; forming on the other surface of the semiconductor an electrically conductive substrate forming an ohmic junction with the semiconductor; forming an electrically conductive film by joining on the semiconductor surface whose roughness factor is increased to 5 or greater an electrically conductive material forming a Schottky junction with the semiconductor; and forming on the film a sensitizing dye layer.

The present invention also relates to the process of manufacturing a photoelectric conversion device wherein the steps of forming on an electrically conductive substrate a semiconductor forming an ohmic junction with the substrate and increasing the roughness factor of the surface of the semiconductor on which a Schottky junction is formed, to 5 or greater are conducted by forming an anodize film by anodizing the electrically conductive substrate in an electrolyte solution.

The present invention will be described in more details below.

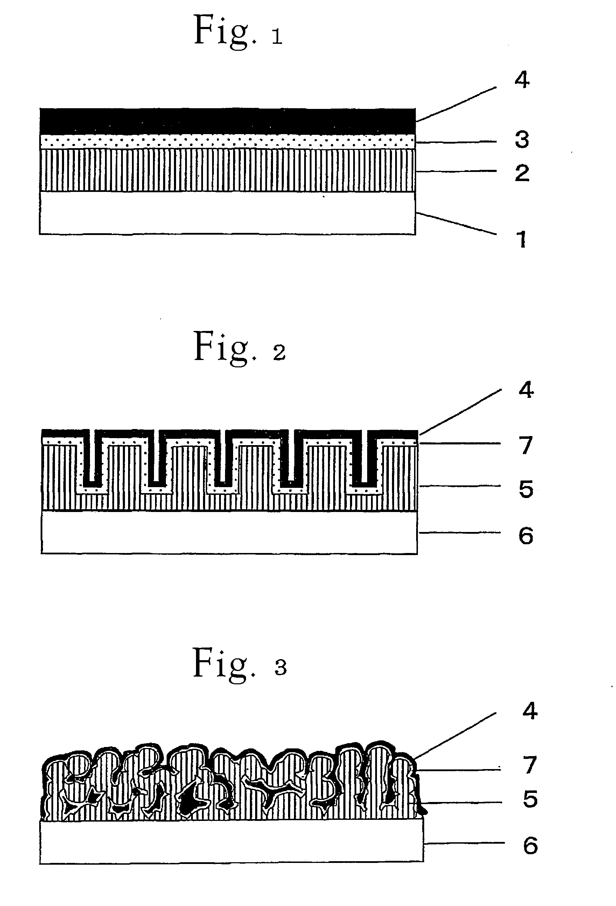

Fig. 2 is a schematic cross-sectional view showing one embodiment of the present invention wherein a semiconductor 5 forms on one surface thereof an ohmic junction with an electrically conductive substrate 6 and on the other surface a Schottky junction with an electrically conductive film 7, on which a sensitizing dye layer 4 is formed.

In the present invention, the semiconductor constituting the photoelectric conversion device denotes a substance with an electric conductivity at room temperature which is intermediate between those of metal and an insulator, i.e., in the order from 10³ to 10⁻¹⁰ S/cm and is either an n-type wherein the charge carriers are electrons, a p-type semiconductor wherein the charge carriers are positive holes, or an intrinsic semiconductor wherein electrons or positive holes can be the charge carriers. The semiconductor may be in any shape such as single crystal, polycrystal or film. Examples of semiconductors which may be used in the present invention include inorganic semiconductors such as elemental semiconductors of elements of group IV of the Periodic Table such as silicon and germanium, group III-V compound semiconductors, metal chalcogenide semiconductors (for example, oxides, sulfides and selenides), and compounds having a perovskite structure (for example, strontium titanate, calcium titanate, sodium titanate, barium titanate and potassium niobate); and organic semiconductors such as perylene derivatives and phthalocyanine derivatives.

Other than n- or p-type inorganic semiconductors, there are some inorganic semiconductors which may be of either type. In order to obtain a semiconductor of either conductive type (p-type or n-type) from any of such inorganic semiconductors, it is doped with an element other than that constituting the inorganic semiconductor. The semiconductor exhibits a conductivity (of p-type or n-type) as result of substitution of a part of the element constituting the semiconductor with the doped impurity. In the case of forming a p-type semiconductor, the impurity may be usually selected from elements whose peripheral electron number is smaller by one than that of the element constituting the semiconductor to be substituted, while in the case of forming an n-type semiconductor, the impurity may be usually selected from elements whose peripheral electron number is larger by one than that of the element constituting the semiconductor to be substituted.

For example, for a group Ib-IIIb-VIb₂ compound semiconductor such as CuInS₂, it is known to add an element of group Vb as an impurity to render the compound a semiconductor of p-type and an element of Group VIIb as an impurity to render the compound a semiconductor of n-type. For a group IIIb-Vb compound semiconductor such as GaN, the p-type and n-type semiconductors may be obtained using an impurity of an element of group IIa and an impurity of an element of group IVb, respectively. For a group IIb-VIb compound semiconductor such as ZnSe, the p-type and n-type semiconductors may be obtained using an impurity of an element of group Vb and an impurity of an element of group VIIb, respectively. Specific examples of the n-type inorganic semiconductor include, but not limited to, cadmium, zinc, lead, silver, antimony, sulfides of bismuth, oxides such as titanium oxide, Si, SiC, and GaAs. Specific examples of the p-type inorganic semiconductor include, but not limited to, tellurium compounds such as CdTe, Si, SiC, GaAs, compound semiconductors containing a monovalent copper such as CuI, GaP, NiO, CoO, FeO, Bi₂O₃, MoO₂, and Cr₂O₃.

Examples of the n-type organic semiconductor include, but not limited to, perylene pigments and derivatives thereof (various derivatives whose substituents bonding to nitrogen atoms are different are known) ; naphthalene derivatives (those wherein the perylene skeleton in a perylene pigment is a naphthalene skeleton instead), and C₆₀ (also referred to as "fullerene").

Examples of the p-type organic semiconductor include, but not limited to, phthalocyanine pigment and derivatives thereof (metal phthalocyanines containing in the center various metals M, metal-free phthalocyanines, and phthalocyanines around which various substituents bond); quinacridone pigments; porphyrin; merocyanine; and derivatives thereof.

The work function Φ is defined as the least amount of energy required to remove an electron from the surface of a conducting material, to a point just outside thereof. The Fermi level E_{F} is defined as an energy level wherein an existence probability of electrons at each level at a certain temperature is one-half, i.e., the densities of electrons and holes are equal to each other. For a semiconductor of n-type, when its Fermi level E_{Fn} is substantially equal to or smaller than the work function Φ of an electrically conductive material, it forms an ohmic junction therewith. The ohmic junction used herein denotes a junction state of two substances across which an electric current is generated upon application of a potential difference in accordance with Ohm's law. When the Fermi level E_{Fn} of an n-type semiconductor is larger than the work function Φ of an electrically conductive material, it forms a Schottky junction therewith. The Schottky junction used herein denotes a junction of two substances wherein the potential barrier for the electrons of the semiconductor is formed at the interface between an electrically conductive material and the n-type semiconductor and thus the flow of the electrons into a metal requires the application of a potential difference higher than the potential barrier. For a semiconductor of p-type, when its Fermi level E_{Fp} is substantially equal to or larger than the work function Φ of an electrically conductive material, it forms an ohmic junction therewith, and when its Fermi level E_{Fp} is smaller than the work function of an electrically conductive material, it forms a Schottky junction therewith.

The electromotive force of a photoelectric conversion device is determined by the height ΔΦ of the Schottky barrier created after a Schottky junction is formed between the semiconductor and the electrically conductive material. A too large ΔΦ would cause a decrease in the percentage of sunlight to be absorbed by the dye. A too small ΔΦ would cause not only a failure to obtain a sufficient electromotive force but also an increase in the charge recombination probability when the dye absorbs sunlight. Therefore, in the present invention, the ΔΦ is preferably from 0.2 eV to 2.5 eV, more preferably from 0.4 eV to 1.5 eV in order to obtain sufficient photoelectric conversion capabilities.

The work function of an electrically conductive material may be determined by any conventional method. For example, the work function may be determined by measuring the temperature dependence of the electric current generated by thermionic emission from an electrically conductive material, the threshold wavelength of light irradiated to a solid, required to eject photoelectrons to generate a current, or the contact potential difference between a conductive material and a reference solid whose work function is already known.

The Fermi level of an n-type semiconductor is substantially an energy level at the lower end of the conduction band. The Fermi level of a p-type semiconductor is substantially an energy level at the upper end of the valence band and thus can be estimated from the energy at the upper end of the valence band and the energy gap.

Theoretically, the Schottky barrier height is equal to the difference ΔΦ between the Fermi level of a semiconductor and the work function of an electrically conductive material. However, in a practical sense, the actual Schottky barrier height varies largely depending on the structure and quantity of the surface level. Therefore, the Schottky barrier height is determined by applying a potential difference between a semiconductor and metal after they are joined together and then measuring how the current flows therebetween, rather than estimating from the difference between the Fermi level of a semiconductor and the work function of an electrically conductive material. More specifically, the Schottky barrier height ΔΦ equals to the potential difference at which the current starts to flow. Similarly, when a potential difference is applied between two substance, and if the current corresponding to the potential difference flows in accordance with Ohm's law, it is confirmed that an ohmic junction is formed. In the present invention, the ohmic junction, Schottky junction and ΔΦ are confirmed or estimated by measuring the current flow caused by applying a potential difference between two substances joined together.

Examples of the n-type oxide semiconductor include oxides of any metal such as titanium, tin, zinc, iron, tungsten, zirconium, hafnium, strontium, indium, cerium, yttrium, lanthanum, vanadium, niobium, and tantalum. The n-type semiconductor is preferably an oxide of titanium, tantalum, niobium or zirconium. When the n-type semiconductor is used, a material which is low in work function and forms an ohmic junction therewith is used as an electrically conductive substrate. For example, when titanium oxide is used as an oxide semiconductor, the electrically conductive substrate may be any electrically conductive film formed of metal such as lithium, sodium, magnesium, aluminum, potassium, calcium, scandium, titanium, vanadium, manganese, zinc, gallium, arsenic, rubidium, strontium, yttrium, zirconium, niobium, silver, cadmium, indium, cesium, barium, lanthanum, hafnium, tantalum, thallium, lead and bismuth; an alloy of any of these metals, a compound containing any of these metals, or a metal oxide of tin or zinc doped with a small amount of other metal element, such as indium tin oxide (ITO(In₂O₃:Sn)), fluorine doped tin oxide (FTO(SnO₂:F)) and aluminum doped zinc oxide (AZO(ZnO:Al)). When titanium oxide is used, it is preferable to use titanium, or an alloy or transparent electrically conductive film composed of mainly titanium as an electrically conductive substrate. When either one of tantalum oxide, niobium oxide or zirconium oxide is used, it is preferable to use the metal corresponding to each oxide, or an alloy or transparent electrically conductive film composed of mainly the metal.

The photoelectric conversion device according to the present invention comprises a semiconductor, an electrically conductive substrate arranged on one surface of the semiconductor and forming an ohmic junction therewith, an electrically conductive film arranged on the other surface and forming a Schottky junction with the semiconductor, and a sensitizing dye layer arranged on the electrically conductive film, the roughness factor of the surface of the semiconductor forming a Schottky junction being 5 or greater.

The photoelectric conversion device may be manufactured by a process comprising steps of: forming on an electrically conductive substrate a semiconductor forming an ohmic junction with the substrate; increasing the roughness factor of the surface of the semiconductor forming a Schottky junction with an electrically conductive film to 5 or greater; forming an electrically conductive film by joining on the semiconductor surface whose roughness factor is increased to 5 or greater an electrically conductive material forming a Schottky junction with the semiconductor; and forming on the film a sensitizing dye layer.

Alternatively, the photoelectric conversion device may be manufactured by a process comprising steps of: increasing the roughness factor of one surface of a semiconductor to 5 or greater; forming on the other surface of the semiconductor an electrically conductive substrate forming an ohmic junction with the semiconductor; forming an electrically conductive film by joining on the semiconductor surface whose roughness factor is increased to 5 or greater an electrically conductive material forming a Schottky junction with the semiconductor; and forming on the film a sensitizing dye layer.

An ohmic junction between one surface of the semiconductor 5 and the electrically conductive substrate 6 may be formed by forming a semiconductor film on an electrically conductive substrate or alternatively forming an electrically conductive substrate in the form of film on a semiconductor.

There is no particular restriction on the thickness of the electrically conductive substrate as long as the surface electric conductivity thereof is not impaired. The surface resistance of the substrate is preferably 1000 Ω/sq. or lower, more preferably 100Ω/sq. or lower.

Examples of methods for forming a semiconductor film on an electrically conductive substrate to form an ohmic junction thereon include vapor phase methods such as vacuum deposition, chemical deposition and sputtering; liquid phase methods such as spin-coating, dip-coating and liquid phase growth; solid phase methods such as thermal spraying and a method using a solid phase reaction; a heat treatment method wherein an electrically conductive substrate is heated thereby forming on its metal surface its metal oxide film; a method wherein a colloid of semiconductor fine particles is coated on an electrically conductive substrate; and anodization.

Anodidization is a method wherein a voltage is applied to the metal surface of an electrically conductive substrate which is used as an anode and any electrically conductive material which is used as a cathode placed in an aqueous solution so as to oxidize the metal of the anode electrochemically, thereby forming the metal oxide with a few µm thickness on the surface of the substrate. Anodization is advantageous in that it can provide a strong adhesion between the substrate and the oxide and an excellent electrical junction and is faster in film making than the other oxide film making methods and capable to form a uniform film on a substrate which has even a large area.

When the metal oxide of an electrically conductive substrate is used as a semiconductor, such an oxide semiconductor may be obtained by directly anodizing the substrate. In the other cases, an oxide semiconductor is formed on an electrically conductive substrate by forming on the surface thereof the metal reductant of a semiconductor by vacuum-deposition or the like and then oxidizing the metal reductant.

On the other surface of the semiconductor 5 is formed the electrically conductive film 7 forming a Schottky junction therewith. In the present invention, the roughness factor of the semiconductor surface forming a Schottky junction with an electrically conductive film is necessarily 5 or greater.

The roughness factor is defined as the ratio of an actual/effective surface area to the apparent surface area, i.e., the area of projection of this surface of the semiconductor. The roughness factor may be determined by measuring the adsorption of nitrogen molecules or the surface adsorption amount of coloring molecules or observing the surface profile of a semiconductor using an AFM (atomic force microscope).

The roughness factor varies largely depending on the short-circuit current of a photoelectric conversion device. In the present invention, the roughness factor is 5 or greater, preferably 10 or greater, more preferably 20 or greater, and further more preferably 50 or greater. There is no particular restriction on the upper limit of the roughness factor which is, however, usually 3000 or less, preferably 2000 or less.

Examples of methods of increasing the roughness factor of a surface of a semiconductor include, but not limited to, those wherein a semiconductor layer is formed on a surface of a porous material with a large roughness factor by a vapor phase method such as ion-beam etching, photoelectric-chemical etching, vacuum deposition, chemical deposition or sputtering, a liquid phase method such as spin-coating, dip-coating or liquid phase growth, or a solid phase method such as thermal spraying or a method using a solid phase reaction; wherein a semiconductor layer is formed on a surface of a porous material with a large roughness factor by any of the foregoing methods and then the material is removed therefrom; wherein a colloid solution of semiconductor fine particles is coated on a semiconductor; or wherein a semiconductor is anodized.

In a method wherein a semiconductor film is formed by coating a colloid solution of semiconductor fine particles, a colloid solution containing semiconductor fine particles and a slight amount of an organic polymer is coated on an electrically conductive substrate, dried, and heated at an elevated temperature so as to decompose or vaporize the organic polymer. As a result, fine pores are formed in the resulting semiconductor film thereby increasing the roughness factor thereof.

In a method using anodization, a step of forming a semiconductor forming an ohmic junction with an electrically conductive substrate thereon may be conducted in parallel with a step of increasing the roughness factor of the semiconductor surface to 5 or greater. That is, a voltage is applied to the metal surface of the electrically conductive substrate which is used as an anode and any electrically conductive material which is used as a cathode in an aqueous solution so as to electrochemically oxidize the metal of the anode thereby obtaining on the substrate the metal oxide thereof with a few µm thickness and a roughness factor of 5 or greater.

Preferred examples of the electrolyte solution used in anodization include alkali aqueous solutions of such as sodium hydroxide, aqueous solutions dissolving sulfuric acid, hydrofluoric acid, phosphoric acid , hydrogen peroxide or a mixed acid of any of these acids, and those dissolving both a glycerophosphate and a metal acetate. Examples of the glycerophosphate include sodium glycerophosphate and calcium glycerophosphate. Sodium glycerophosphate is preferably used because it is significantly dissoluble in water. Any metal acetate may be used. Preferred metal acetates include acetates of alkali metals or alkaline earth metals and lanthanum acetate because they are well-dissolved in an aqueous solution of a glycerophosphate and can provide stable anodization to a certain high voltage.

It is known that when titanium is anodized using any of these electrolyte solutions at a voltage equal to or higher than a voltage at which spark discharge is generated, the roughness factor is increased because of formation of discharge traces. Furthermore, a highly crystallized anodize film is obtained because it is locally crystallized with heat generated by discharge. Finer pores can be formed by forcing an anodize film to take ions from an electrolyte solution by heat generated by spark discharge upon anodization and then eluting the ions. After elusion of the ions, thousands of fine pores are formed and thus the roughness factor of the resulting anodize film is increased, resulting in an increase in the surface area thereof.

It is known that when anodization is conducted using an alkali aqueous solution of such as sodium hydroxide or an acid aqueous solution of sulfuric acid or hydrofluoric acid, the film will have very fine pores of several tens of nm and a large roughness factor due to formation and dissolution of an oxide even though a relatively small voltage is applied. In this case, the resulting film is likely to be low in crystallinity and thus may be heated to facilitate the crystallization of the film after anodization.

Examples of methods of forming an electrically conductive film by joining an electrically conductive material to a semiconductor with a surface roughness factor of 5 or greater include electrolytic plating, electroless plating, metal deposition such as sputtering, ion-plating and CVD (chemical vapor deposition), a method wherein a metal colloid is adhered on a surface of a semiconductor, a method wherein a paste of coating containing an electrically conductive material is coated and then sintered, a method wherein such a paste of coating is coated and then reduced and sintered, a method wherein a compound containing an electrically conductive material is coated by vapor deposition and then sintered or reduced and sintered, and a method of any combination of the foregoing methods. The diameter of metal particles contained in a colloid is 100 nm or smaller, preferably 10 nm or smaller. A metal colloid positively charged is likely to well-adhere to an oxide semiconductor. The use of such a colloid makes it possible to easily allow a metal to adhere to an inorganic compound.

When a semiconductor is an n-type oxide semiconductor, it is preferable to use an electrically conductive material which is large in work function and likely to form a Schottky junction with the semiconductor as an electrically conductive film. For example, when titanium oxide is used as an oxide semiconductor, preferred examples of such an electrically conductive material include, but not limited to, metals such as beryllium, boron, carbon, silicon, chromium, iron, cobalt, nickel, copper, germanium, selenium, molybdenum, ruthenium, rhodium, palladium, antimony, tellurium, tungsten, rhenium, osmium, iridium, platinum, gold and mercury, alloys of these metals and compounds containing any of these metals.

There is no particular restriction on the thickness of the electrically conductive film thus formed as long as transfer of electrons from the sensitized dye layer 4 to the semiconductor 5 is not bothered. However, the thickness is preferably from 1 nm to 200 nm, more preferably from 10 nm to 50 nm.

The surface resistance of the electrically conductive film is better if it is lower. The surface resistance is preferably from 1000 Ω/sq. or lower, more preferably 100 Ω/sq. or lower.

On the electrically conductive material is arranged a sensitizing dye layer 4.

The dye sensitization of a semiconductor is defined as that when a dye is adsorbed on a surface of a semiconductor, the physical and chemical response thereof occurring by light extends to the absorption wavelength range of the dye. The dye used for this dye sensitization is defined as a sensitizing dye. Various semiconductors and dyes may be used as the sensitizing dye. Here it is important for the sensitizing dye that the oxidation-reduction product is stable. Furthermore, the electric potential of electrons excited in the light absorption layer and that of holes produced by photoexcitation in the optical absorption layer are also important for the sensitizing dye. It is also important that the light absorption edge energy of the sensitizing dye be an energy equal to or more than the energy of a Schottky barrier formed by the semiconductor and the electrically conductive film. More specifically, when the semiconductor is an n-type semiconductor, it is important that the lowest unoccupied molecular orbital (LUMO) potential of the photoexcited dye and the conduction band potential in the semiconductor be higher than the conduction band potential of the n-type semiconductor and also the potential of holes produced by photoexcitation in the light absorption layer be lower than the Fermi level created after the n-type semiconductor is joined to the electrically conductive film. When the semiconductor is a p-type semiconductor, it is important that the potential of holes produced by photoexcitation in the light absorption layer be lower than the valence band level of the p-type semiconductor and also the LUMO potential of the photoexcited dye and the conduction band potential in the semiconductor be higher than the Fermi level created after the p-type semiconductor is joined to the electrically conductive film. In order to enhance the photoelectric conversion efficiency, it is also important to lower the probability of recombination of electrons-holes excited in the vicinity of the light absorption layer.

Examples of semiconductors which may be used as the sensitizing dye layer include i-type amorphous semiconductors having a large absorptivity coefficient, direct transition type semiconductors, and particle semiconductors exhibiting a quantum size effect and absorbing visible light efficiently.

Examples of dyes which may be used as the sensitizing dye include metal complex dyes, organic dyes, and natural dyes. The dye is preferably any of those containing in molecules a functional group such as carboxyl, hydroxyl, sulfonyl, phosphonyl, carboxyalkyl, hydroxyalkyl, sulfonylalkyl and phosphonylalkyl group. Examples of the metal complex dye include complexes of ruthenium, osmium, iron, cobalt, zinc and mercury (mercurochrome), metal phthalocyanines and chlorophyll. Examples of the organic dyes include, but not limited to, cyanine dyes, hemicyanine dyes, merocyanine dyes, xanthene dyes, triphenylmethane dyes, and metal-free phthalocyanines. Generally, one or more of the various semiconductors, one or more of the metal complex dyes and one or more of the organic dyes may be mixed in order to widen the photoelectric conversion wavelength region as much as possible and enhance the photoelectric conversion efficiency. The dyes to be mixed and the ratio thereof may be selected in conformity with the wavelength of the target light source and light intensity distribution thereof.

The dye may be adhered to the electrically conductive film by spray- or spin-coating thereon a solution obtained by dissolving the dye in a solvent and then drying out the solvent. In this case, the substrate, i.e., film may be heated to an appropriate temperature. Alternatively, the film may be dipped into such a solution such that the dye is adsorbed thereto. There is no particular restriction on dipping time as long as the dye is sufficiently adsorbed to the film. However, the dipping time is preferably from 1 to 30 hours, particularly preferably 5 to 20 hours. If necessary, the film or solvent may be heated upon dipping. The concentration of the dye in the solution is from 1 to 1000 mmol/l, preferably from 10 to 500 mmol/l.

There is no particular restriction on the solvent which may be used in the present invention. However, water and an organic solvent are preferably used. Examples of the organic solvent include alcohols such as methanol, ethanol, 1-propanol, 2-propanol, 1-butanol, 2- butanol and t- butanol, nitrile-based solvents such as acetonitrile, propionitrile, methoxypropionitrile and glutanitrile, ketones such as benzene, toluene, o-xylene, m-xylene, p-xylene, pentane, heptane, hexane, cyclohexane, acetone, methyl ethyl ketone, diethyl ketone and 2-butanone, diethyl ether, tetrahydrofuran, ethylene carbonate, propylene carbonate, nitromethane, dimethylformamide, dimethylsulfoxide, hexamethylphosphoamide, dimethoxyethane, γ-butyrolactone, γ-valerolactone, sulfolane, adiponitrile, methoxyacetonitrile, dimethylacetoamide, methylpyrrolidinone, dimethylsulfoxide, dioxolane, trimethyl phosphate, triethyl phosphate, tripropyl phosphate, ethyldimethyl phosphate, tributyl phosphate, tripentyl phosphate, trihexyl phosphate, triheptyl phosphate, trioctyl phosphate, trinonyl phosphate, tridecyl phosphate, tris(trifluoromethyl)phosphate, tris(pentafluoroethyl)phosphate, triphenylpolyethylene glycol phosphate, and polyethylene glycol.

In order to allow light to reach to the dye layer, light may be irradiated from the dye layer side or both from the dye layer and the electrically conductive substrate 6 side when the substrate is a transparent substrate. With the objective of enhancing the photoelectric conversion efficiency, it is preferable that light be made incident from the dye layer side and reflected by the electrically conductive substrate 6 with a planished surface on which the oxide semiconductor 5 is formed.

In order to increase the weathering resistance of the photoelectric conversion device, the whole or a part other than the electrically conductive substrate thereof is preferably coated. The coating material may be resin. When the light incident side of the device is coated, the coating material is preferably light-transmissive.

### [Applicability in the Industry]

As described above, the present invention can provide a photoelectric conversion device increased in short-circuit current because the dye absorbing amount of the device is increased. Furthermore, the present invention can provide a solid state type photoelectric conversion device which can be manufactured by a simple procedure and has excellent characteristics such as mechanical strength.

### [Best Mode for Carrying out the Invention]

The present invention will be described in more details with reference to the following examples but is not limited thereto.

### (Example 1)

A dye sensitizing photoelectric conversion device according to the present invention was manufactured by the following procedures. First of all, a titanium substrate with a size of 5 x 5 cm and a thickness of 1 mm was prepared and masked on its one surface with an epoxy resin. The titanium substrate was electrolytic polished using a methanol-sulfuric acid mixed solution to planish the other surface. After the electrolytic polishing, the surface profile of the substrate was observed with an AFM (atomic force microscope) and it was confirmed that the substrate had a very smooth surface structure. The roughness factor of the substrate surface was 1.04.

Thereafter, the titanium substrate was anodized by applying a voltage of 10 V for 30 minutes in an aqueous electrolyte solution containing 0.5 mass% of hydrofluoric acid thereby forming a titanium oxide film on the substrate. The electrolyte solution was set at a temperature of 16°C.

Thereafter, the substrate with the resulting titanium oxide film was heated at a temperature of 500°C for 30 minutes under an atmosphere thereby forming the film into a crystalline titanium oxide film. The film thus obtained was an anatase type crystal and had a thickness of 200 nm. The film was also confirmed to be porous. When an electrical potential was applied between the titanium substrate and the titanium oxide film, the current value corresponding to the potential difference was observed. It was thus confirmed that the junction between the substrate and the film was an ohmic junction.

The substrate with the titanium oxide film was immersed in an ethanol solution containing 4 x 10⁻⁴ mol/l of Rhoadamine B which is an organic dye and allowed to stand for a whole day and night so as to allow Rhoadamine B to be adsorbed to the film. After adsorption, the substrate with the titanium oxide film was immersed in an aqueous solution containing 1 x 10⁻² mol/l of sodium hydroxide so as to desorb Rhoadamine B. The amount of Rhoadamine B having been adsorbed to the film was determined by measuring the absorbancy of the solution. The roughness factor of the film was calculated from the amount and was found to be 50.

Thereafter, a 40 nm thickness gold was deposited on the titanium oxide film by electroless plating. When a negative potential to gold was applied to the titanium oxide, a current was observed at a potential difference of 0.8 V. The ΔΦ was thus estimated as 0.8 V. The substrate was heated at a temperature of 100°C and then immersed in an aqueous solution containing 4 x 10⁻⁴ mol/l of a mercurochrome dye and allowed to stand at room temperature for 15 hours. As a result, the mercurochrome sensitizing dye layer was adsorbed and coated on the gold formed on the titanium oxide film.

A pseudo sunlight with a light intensity of 100 mw/cm² was irradiated to the resulting photoelectric conversion device so as to measure the electromotive force thereof. As a result, the short circuit current and open-circuit voltage were 0.7 mA per cm² and 0.63 V, respectively.

### (Example 2)

A dye sensitizing photoelectric conversion device according to the present invention was manufactured by the following procedures. First of all, a titanium substrate with a size of 5 x 5 cm and a thickness of 1 mm was prepared and masked on its one surface with an epoxy resin. The titanium substrate was electrolytic polished using a methanol-sulfuric acid mixed solution to planish the other surface. After the electrolytic polishing, the surface profile of the substrate was observed with an AFM (atomic force microscope) and it was confirmed that the substrate had a very smooth surface structure. The roughness factor of the substrate surface was 1.04.

Thereafter, the titanium substrate was anodized by applying a voltage of 20 V for 20 minutes in an aqueous electrolyte solution containing 0.5 mass% of hydrofluoric acid thereby forming a titanium oxide film on the substrate. The electrolyte solution was set at a temperature of 16°C.

Thereafter, the substrate with the resulting titanium oxide film was heated at a temperature of 500 °C for 30 minutes under an atmosphere thereby forming the film into a crystalline titanium oxide film. The film thus obtained was an anatase type crystal and had a thickness of 200 nm. The film was also confirmed to be tubular. When an electrical potential was applied between the titanium substrate and the titanium oxide film, the current value corresponding to the potential difference was observed. It was thus confirmed that the junction between the substrate and the film was an ohmic junction.

The substrate with the titanium oxide film was immersed in an ethanol solution containing 4 x 10⁻⁴ mol/l of Rhoadamine B which is an organic dye and allowed to stand for a whole day and night so as to allow Rhoadamine B to be adsorbed to the film. After adsorption, the substrate with the titanium oxide film was immersed in an aqueous solution containing 1 x 10⁻² mol/l of sodium hydroxide so as to desorb Rhoadamine B. The amount of Rhoadamine B having been adsorbed to the film was determined by measuring the absorbancy of the solution. The roughness factor of the film was calculated from the amount and was found to be 32.

Thereafter, a 40 nm thickness gold was deposited on the titanium oxide film by electroless plating. When a negative potential to gold was applied to the titanium oxide, a current was observed at a potential difference of 0.8 V. The ΔΦ was thus estimated as 0.8 V. The substrate was heated at a temperature of 100°C and then immersed in an aqueous solution containing 4 x 10⁻⁴ mol/l of a mercurochrome dye and allowed to stand at room temperature for 15 hours. As a result, the mercurochrome sensitizing dye layer was adsorbed and coated on the gold formed on the titanium oxide film.

A pseudo sunlight with a light intensity of 100 mW/cm² was irradiated to the resulting photoelectric conversion device so as to measure the electromotive force thereof. As a result, the short circuit current and open-circuit voltage were 0.6 mA per cm² and 0.62 V, respectively.

### (Example 3)

A dye sensitized photoelectric conversion device according to the present invention was manufactured by the following procedures. First of all, an ITO glass substrate with a size of 5 x 5 cm and a thickness of 3 mm was prepared, and titanium of a thickness of 1000 nm was laminated on the ITO by vacuum-deposition. The surface profile of the titanium was observed with an AFM (atomic force microscope) and it was confirmed that the titanium had a very smooth surface structure. The roughness factor of the titanium surface was 1.02.

Thereafter, the deposited titanium was anodized in an aqueous electrolyte solution containing 1.5 mol/l of sulfuric acid and 0.3 mol/l of hydrogen peroxide by constant-current electrolysis until the generated voltage reached at 150 V thereby forming a titanium oxide film on the substrate. The current density and the temperature of the electrolyte solution were set to 30 mA/cm² and 16 °C, respectively. The film thus obtained was a rutile type crystal and had a thickness of 4000 nm. The film was also confirmed to be porous. When an electrical potential was applied between the ITO and the titanium oxide film, the current value corresponding to the potential difference was observed. It was thus confirmed that the junction between the substrate and the film was an ohmic junction.

The ITO glass substrate with the titanium oxide film was immersed in an ethanol solution containing 4 x 10⁻⁴ mol/l of Rhoadamine B which is an organic dye and allowed to stand for a whole day and night so as to allow Rhoadamine B to be adsorbed to the film. After adsorption, the substrate with the titanium oxide film was immersed in an aqueous solution containing 1 x 10⁻² mol/l of sodium hydroxide so as to desorb Rhoadamine B. The amount of Rhoadamine B having been adsorbed to the film was determined by measuring the absorbancy of the solution. The roughness factor of the film was calculated from the amount and was found to be 120.

Thereafter, a 30 nm thickness gold was deposited on the titanium oxide film by electroless plating. When a negative potential to gold was applied to the oxidized titanium, a current was observed at a potential difference of 0.8 V. The ΔΦ was thus estimated as 0.8 V. The substrate was heated at a temperature of 100°C and then immersed in an aqueous solution containing 4 x 10⁻⁴ mol/l of a mercurochrome dye and allowed to stand at room temperature for 15 hours. As a result, the mercurochrome sensitizing dye layer was adsorbed and coated on the gold formed on the titanium oxide film.

A pseudo sunlight with a light intensity of 100 mW/cm² was irradiated to the resulting photoelectric conversion device so as to measure the electromotive force thereof. As a result, the short circuit current and open-circuit voltage were 0.4 mA per cm² and 0.70 V, respectively.

### (Example 4)

A dye sensitized photoelectric conversion device according to the present invention was manufactured by the following procedures. First of all, a rutile type titanium oxide single crystal with a size of 1 x 1 cm, a thickness of 0.2 mm and a widened (001) surface was prepared. The surface profile of the single crystal was observed with an AFM (atomic force microscope) and it was confirmed that the single crystal had a very smooth surface structure. The roughness factor of the single crystal surface was 1.01.

The single crystal was anodized in an aqueous solution containing 1 mol/l of sulfuric acid at a constant potential of 1.0 V using a reference silver-silver chloride electrode while a 200 mW/cm² light was irradiated from a high-pressure mercury arc lamp so as to render the single crystal porous. The resulting titanium oxide was immersed in an ethanol solution containing 4 x 10⁻⁴ mol/l of Rhoadamine B which is an organic dye and allowed to stand for a whole day and night so as to allow Rhoadamine B to be adsorbed to the titanium oxide. After adsorption, the titanium oxide was immersed in an aqueous solution containing 1 x 10⁻² mol/l of sodium hydroxide so as to desorb Rhoadamine B. The amount of Rhoadamine B having been adsorbed to the film was determined by measuring the absorbancy of the solution. The roughness factor of the film was calculated from the amount and was found to be 200.

A 800 nm thickness ITO film was formed on one surface of the titanium oxide by sputtering. When a potential was applied between the ITO and the titanium oxide, the current value corresponding to the potential difference was observed. It was thus confirmed that the junction between the substrate and the film was an ohmic junction.

Thereafter, a 30 nm thickness gold was deposited on the other surface of the titanium oxide film by electroless plating. When a negative potential to gold was applied to the oxidized titanium, a current was observed at a potential difference of 0.8 V. The △Φ was thus estimated as 0.8 V. The substrate was heated at a temperature of 100°C and then immersed in an aqueous solution containing 4 x 10⁻⁴ mol/l of a mercurochrome dye and allowed to stand at room temperature for 15 hours. As a result, the mercurochrome sensitizing dye layer was adsorbed and coated on the gold formed on the titanium oxide film.

A pseudo sunlight with a light intensity of 100 mW/cm² was irradiated to the resulting photoelectric conversion device so as to measure the electromotive force thereof. As a result, the short circuit current and open-circuit voltage were 0.8 mA per cm² and 0.65 V, respectively.

### (Comparative Example 1)

A titanium substrate with a size of 5 x 5 cm and a thickness of 1 mm was prepared and masked on its one surface with an epoxy resin. The titanium substrate was electrolytic polished using a methanol-sulfuric acid mixed solution to planish the other surface. After the electrolytic polishing, the surface profile of the substrate was observed with an AFM (atomic force microscope) and it was confirmed that the substrate had a very smooth surface structure. The roughness factor of the substrate surface was 1.04.

The titanium substrate was sintered for 3 hours thereby forming a titanium oxide film thereon. The film was a mix of anatase and rutile types and maintained a flat surface profile.

When an electrical potential was applied between the titanium substrate and the oxidized titanium film, the current value corresponding to the potential difference was observed. It was thus confirmed that the junction between the substrate and the film was an ohmic junction.

The titanium oxide film was immersed in an ethanol solution containing 4 x 10⁻⁴ mol/l of Rhoadamine B which is an organic dye and allowed to stand for a whole day and night so as to allow Rhoadamine B to be adsorbed to the film. After adsorption, the substrate with the oxidized titanium film was immersed in an aqueous solution containing 1 x 10⁻² mol/l of sodium hydroxide so as to desorb Rhoadamine B. The amount of Rhoadamine B having been adsorbed to the film was determined by measuring the absorbancy of the solution. The roughness factor of the film was calculated from the amount and was found to be 2.8.

Thereafter, a 40 nm thickness gold was deposited on the titanium oxide film by electroless plating. When a negative potential to gold was applied to the oxidized titanium, a current was observed at a potential difference of 0.8 V. The ΔΦ was thus estimated as 0.8 V. The substrate was heated at a temperature of 100°C and then immersed in an aqueous solution containing 4 x 10⁻⁴ mol/l of a mercurochrome dye and allowed to stand at room temperature for 15 hours. As a result, the mercurochrome sensitizing dye layer was adsorbed and coated on the gold formed on the oxidized titanium film.

A pseudo sunlight was irradiated to the resulting photoelectric conversion device so as to measure the electromotive force thereof. As a result, the short circuit current and open-circuit voltage were about 20 µA per cm² and 0.63 V, respectively.

### [Brief Description of the Drawings]

Fig. 1 is a sectional view of a conventional photoelectric conversion device.
Fig. 2 is a schematic sectional view of one example of the photoelectric conversion device according to the present invention.
Fig. 3 is a schematic sectional view of another example of the photoelectric conversion device according to the present invention.

### (Description of Numerals)

1. titanium electrode
2. titanium oxide
3. gold electrode
4. dye molecular layer (sensitizing dye layer)
5. semiconductor
6. electrically conductive substrate
7. electrically conductive film

## Claims

1. A photoelectric conversion device which comprises a semiconductor, an electrically conductive substrate arranged on one surface of the semiconductor and forming an ohmic junction therewith, an electrically conductive film arranged on the other surface and forming a Schottky junction with the semiconductor, and a sensitizing dye layer arranged on the electrically conductive film, the roughness factor of the surface of the semiconductor forming a Schottky junction being 5 or greater.

2. The photoelectric conversion device according to claim 1 wherein the Schottky barrier value between said semiconductor and said electrically conductive film forming a Schottky junction therewith is from 0.2 eV to 2.5 eV.

3. The photoelectric conversion device according to claim 1 wherein said semiconductor is an oxide semiconductor.

4. The photoelectric conversion device according to claim 3 wherein said oxide semiconductor is selected from the group consisting of titanium oxide, tantalum oxide, niobium oxide and zirconium oxide.

5. The photoelectric conversion device according to claim 1 wherein said electrically conductive substrate forming an ohmic junction with said semiconductor is a transparent electrically conductive substrate formed of a metal selected from the group consisting of titanium, tantalum, niobium and zirconium, an alloy containing mainly any of these metals, or an oxide of any of these metals.

6. A process of manufacturing a photoelectric conversion device which comprises steps of: forming on an electrically conductive substrate a semiconductor forming an ohmic junction with said substrate; increasing the roughness factor of the surface of said semiconductor forming a Schottky junction with an electrically conductive film to 5 or greater; forming an electrically conductive film by joining on said semiconductor surface whose roughness factor is increased to 5 or greater an electrically conductive material forming a Schottky junction with said semiconductor; and forming on said film a sensitizing dye layer.

7. A process of manufacturing a photoelectric conversion device which comprises steps of: increasing the roughness factor of one surface of a semiconductor to 5 or greater; forming on the other surface of said semiconductor an electrically conductive substrate forming an ohmic junction with said semiconductor; forming an electrically conductive film by joining on said semiconductor surface whose roughness factor is increased to 5 or greater an electrically conductive material forming a Schottky junction with said semiconductor; and forming on said film a sensitizing dye layer.

8. The process of manufacturing a photoelectric conversion device according to claim 1 wherein said steps of forming on an electrically conductive substrate a semiconductor forming an ohmic junction with the substrate and increasing the roughness factor of the surface of the semiconductor on which a Schottky junction is formed, to 5 or greater are conducted by forming an anodize film by anodizing the electrically conductive substrate in an electrolyte solution.
